(19) Europäisches Patentamt
European Patent Office
Office européen des brevets

(11) **EP 3 287 796 B1**

(12) **EUROPÄISCHE PATENTSCHRIFT**

(45) Veröffentlichungstag und Bekanntmachung des Hinweises auf die Patenterteilung:
**03.03.2021 Patentblatt 2021/09**

(51) Int Cl.:
*G01R 31/52* (2020.01)  *G01R 31/08* (2020.01)
*H02H 9/08* (2006.01)  *H01F 29/14* (2006.01)
*G01R 31/11* (2006.01)  *H02H 7/26* (2006.01)

(21) Anmeldenummer: **17174328.9**

(22) Anmeldetag: **02.06.2017**

(54) **VERFAHREN UND VORRICHTUNG ZUR KOMPENSATION EINES ERDSCHLUSSES**

METHOD AND DEVICE FOR COMPENSATING A GROUND FAULT

PROCÉDÉ ET DISPOSITIF POUR LA COMPENSATION D'UN DÉFAUT À LA TERRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.06.2016 DE 102016110420**

(43) Veröffentlichungstag der Anmeldung:
**28.02.2018 Patentblatt 2018/09**

(73) Patentinhaber: **EnBW Energie Baden-Württemberg AG 76131 Karlsruhe (DE)**

(72) Erfinder:
• **Beck, Wolfgang**
  **88400 Biberach (DE)**
• **Oechsle, Fred**
  **71642 Ludwigsburg (DE)**
• **Christian, Jochen**
  **90574 Rosstal (DE)**
• **Engel, Marcel**
  **75179 Pforzheim (DE)**

(74) Vertreter: **DREISS Patentanwälte PartG mbB Friedrichstraße 6 70174 Stuttgart (DE)**

(56) Entgegenhaltungen:
EP-A2- 2 362 514   WO-A1-2016/029890
WO-A2-02/15355   DE-A1- 4 413 649
DE-A1- 4 429 310   DE-A1- 10 215 025
DE-A1- 19 525 417   DE-A1-102007 017 543
DE-B1- 2 711 629   DE-C- 702 814

EP 3 287 796 B1

**Beschreibung**

Die Erfindung betrifft ein Verfahren zur Kompensation eines Erdschlusses in einem mehrphasigen Mittel- oder Hochspannungsnetz nach dem Oberbegriff des Anspruchs 1 sowie eine Vorrichtung zur Kompensation des Erdschlusses nach dem Oberbegriff eines nebengeordneten Anspruches.

Es ist bekannt, dass insbesondere bei ausgedehnten Mittel- und Hochspannungsnetzen die Erdkapazität auf unerwünscht hohe Werte ansteigt, die bei einem Erdschluss im Netz zu einem hohen Erdschlussstrom führen. Um diesen Erdschlussstrom zu reduzieren wird in der Praxis eine Erdschlusslöschspule, auch Petersenspule genannt, an einen Sternpunkt des Netzes angeschlossen. Diese Erdschlusslöschspulen sind derart ausgestaltet, dass sie Erdschlussströme kompensieren.

Bekannte Erdschlusslöschspulen sind als Tauchkernspulen ausgebildet. Durch ein Verstellen des Luftspaltes des Magnetkreises der Tauchkernspule mit Hilfe einer entsprechenden Verstellmechanik kann die Induktivität der Spule auf die Erdkapazität der zu schützenden Leitungsabschnitte des Netzes abgestimmt werden. Diese Abstimmung und Einstellung der Induktivität geschieht während des Normalbetriebs des Netzes ohne vorhandenen Erdschluss.

Darüber hinaus ist aus der DE 702 814 A eine regelbare Löschinduktivität für den induktiven Erdschlussschutz von Hochspannungsnetzen bekannt. Es ist ein den Eisenkern der Induktivität quermagnetisierender Magnetkreis vorgesehen, dessen magnetomotorische Kraft regelbar bzw. einstellbar ist. Die Stärke der Quermagnetisierung der jeweiligen Länge des geschützten Netzes ist derart angepasst, dass ein gewünschter Kompensationsgrad erreicht wird. Aufgabe der Erfindung ist es daher, eine Vorrichtung zur Kompensation eines Erdschlusses derart weiterzubilden bzw. zu betreiben, dass sowohl ein Normalbetrieb als auch ein Erdschlussbetrieb des Netzes verbessert werden.

WO 0215355 A1 offenbart ein Verfahren zur selektiven Erkennung und Ortung von hochohmigen Erdfehlern.

Die der Erfindung zu Grunde liegende Aufgabe wird durch ein Verfahren nach dem Anspruch 1 sowie durch eine Vorrichtung nach einem nebengeordneten Anspruch gelöst. Vorteilhafte Weiterbildungen sind in den Unteransprüchen angegeben. Für die Erfindung wichtige Merkmale finden sich ferner in der nachfolgenden Beschreibung und in den Zeichnungen, wobei die Merkmale sowohl in Alleinstellung als auch in unterschiedlichen Kombinationen für die Erfindung wichtig sein können, ohne dass hierauf nochmals explizit hingewiesen wird.

Es wird ein Verfahren zum Betreiben einer Vorrichtung zur Kompensation eines Erdschlusses in einem mehrphasigen Mittel- oder Hochspannungsnetz vorgeschlagen, wobei die Vorrichtung eine Kompensationswicklung eines ersten magnetischen Kreises umfasst, und wobei mittels einer Einstellwicklung eines zweiten magnetischen Kreises eine Induktivität der Kompensationswicklung einstellbar ist.

Zumindest eine einen potentiellen Erdschluss charakterisierende Messgröße wird ermittelt. Zumindest ein Betriebsparameter der Einstellwicklung wird in Abhängigkeit von der zumindest einen Messgröße ermittelt, wobei der zumindest eine Betriebsparameter derart ermittelt wird, um die Kompensationswicklung in einem Erdschluss-Betriebspunkt zu betreiben. Ein Erdschlussfall in dem Mittel- oder Hochspannungsnetz wird ermittelt. Wenn der Erdschlussfall ermittelt wird, wird die Einstellwicklung in Abhängigkeit von dem zumindest einen Betriebsparameter derart betrieben, so dass sich die Kompensationswicklung in dem Erdschluss-Betriebspunkt befindet.

So kann auf hochdynamische Art und Weise der Reststrom an einer Erdschluss-Fehlerstelle durch Überlagerung mit dem durch den Erdschluss-Betriebspunkt bedingten Strom durch die Kompensationswicklung wesentlich reduziert werden. Insbesondere kann ausgehend von einem Normalbetrieb des Mittel- oder Hochspannungsnetzes in kürzester Zeit der Erdschluss-Betriebspunkt angefahren werden.

Darüber hinaus findet eine Entkopplung des Erdschluss-Betriebspunktes in dem zweiten Betriebszustand von einem Betriebspunkt in dem ersten Betriebszustand statt. Diese Entkopplung ist insbesondere bei hohen Asymmetrien in Hochspannungsnetzen vorteilhaft, da dort im Normalbetrieb der Erdschluss-Betriebspunkt im Sinne eines idealen Betriebspunkts zu dauerhaft großen Verlagerungsspannungen führen würde und somit nicht einstellbar ist. Insbesondere muss keine Abwägung zwischen dem Normalbetrieb und dem Erdschluss-Betriebspunkt erfolgen, was die Wahl der jeweilig einzustellenden Induktivität betrifft.

In einer vorteilhaften Ausführungsform wird der Betriebsparameter der Einstellwicklung während der ersten Betriebsart vor der Ermittlung des Erdschlussfalls ermittelt.

In einer weiteren vorteilhaften Ausführungsform wird der Betriebsparameter der Einstellwicklung während der zweiten Betriebsart nach der Ermittlung des Erdschlussfalls (68) ermittelt. Selbstverständlich kann die Ermittlung des Betriebsparameters der Einstellwicklung sowohl vor als auch nach der Ermittlung des Erdschlussfalls erfolgen, was eine verbesserte Einstellung der Einstellwicklung ermöglicht.

In einer vorteilhaften Ausführungsform wird in der zweiten Betriebsart eine Oberschwingung eines Erdschlussstromes ermittelt. Ein zu der Oberschwingung gegenphasiges Kompensationssignal im Sinne eines weiteren Betriebsparameters wird ermittelt. Die Einstellwicklung wird in Abhängigkeit von dem zumindest einen Betriebsparameter und dem Kompensationssignal derart betrieben, so dass die Kompensationswicklung in dem Erdschluss-Betriebspunkt eine Amplitude der Oberschwingung des Erdschlussstromes reduziert.

Durch die Aufprägung des Kompensationssignals wird vorteilhaft erreicht, dass die Oberschwingungsströme im Erdschlussreststrom gedämpft werden und der Erdschlussreststrom minimiert wird. Selbstverständlich können auf diese Art und Weise auch weitere Oberschwingungen gedämpft werden, was zu einer weiteren Reduktion des Erdschlussstroms führt.

In einer dritten Betriebsart wird gemäß einem Beispiel der Beschreibung die Einstellwicklung derart betrieben, dass ein periodischer Wechsel zwischen dem Erdschluss-Betriebspunkt und einem Puls-Betriebspunkt stattfindet. Dadurch wird vorteilhaft eine Pulsortung des Erdschlussfehlers ermöglicht. Gleichzeitig wird hierdurch die Schritt- und Berührspannung minimiert, da sich der Erdschluss-Betriebspunkt wie bei einer konventionellen Pulsation mittels zur Spule parallelen, schaltbaren Kapazitäten nicht im überkompensierten Bereich befinden muss.

In einem Beispiel der Beschreibung wird an einem von der Vorrichtung entfernten, in einem Abzweig befindlichen Messpunkt zumindest eine weitere Messgröße ermittelt, wobei ein Erdschluss in dem Abzweig in Abhängigkeit von der weiteren Messgröße ermittelt wird. So kann durch den Messpunkt der Ort des Erdschlusses eingegrenzt werden.

In einer vorteilhaften Weiterbildung des Verfahrens wird in der ersten Betriebsart eine Veränderung in dem Mittel- oder Hochspannungsnetz ermittelt. Der zumindest eine Betriebsparameter wird aktualisiert, wenn die Veränderung ermittelt wird. Es findet somit eine auf die Veränderung folgende unmittelbare Ermittlung des Betriebsparameters statt. Im Falle eines Erdschlusses ist die Vorrichtung damit stets an den veränderten Zustand des Mittel-oder Hochspannungsnetzes angepasst.

In einer vorteilhaften Ausführungsform ist in der ersten Betriebsart die Einstellwicklung unbestromt. Hierdurch wird vorteilhaft Energie bei dem Betrieb der Vorrichtung eingespart. In der ersten Betriebsart müssen lediglich Messungen zur Ermittlung des Erdschluss-Betriebspunkts durchgeführt werden. Eine mechanische Verstellung wie bei der bekannten Petersenspule kann somit entfallen.

Ein weiterer Aspekt der Erfindung betrifft die Vorrichtung zur Kompensation eines Erdschlusses in einem mehrphasigen Mittel- oder Hochspannungsnetz mit einer Kompensationswicklung eines ersten magnetischen Kreises, wobei mittels einer Einstellwicklung eines zweiten magnetischen Kreises eine Induktivität der Kompensationswicklung einstellbar ist. Die Vorrichtung umfasst:

- Mittel, um in einer ersten Betriebsart der Vorrichtung zumindest eine einen potentiellen Erdschluss charakterisierende Messgröße zu ermitteln,
- Mittel, um in der ersten Betriebsart zumindest einen Betriebsparameter der Einstellwicklung in Abhängigkeit von der zumindest einen Messgröße zu ermitteln, wobei der zumindest eine Betriebsparameter derart ermittelt wird, um die Kompensationswicklung in einem Erdschluss-Betriebspunkt zu betreiben,
- Mittel, um einen Erdschlussfall in dem Mittel- oder Hochspannungsnetz zu ermitteln, und
- Mittel, um, wenn der Erdschlussfall ermittelt wird, in einer zweiten Betriebsart der Vorrichtung die Einstellwicklung in Abhängigkeit von dem zumindest einen Betriebsparameter derart zu betreiben, so dass sich die Kompensationswicklung in dem Erdschluss-Betriebspunkt befindet. So können die Oberschwingungsströme im Erdschlussreststrom gedämpft werden.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Es werden für funktionsäquivalente Größen und Merkmale in allen Figuren auch bei unterschiedlichen Ausführungsformen die gleichen Bezugzeichen verwendet. In der Zeichnung zeigen:

Figuren 1 und 4     in schematischer Form eine Vorrichtung zur Kompensation eines Erdschlusses;

Figuren 2 und 9     ein ein schematisch dargestelltes Netzersatzschaltbild;

Figur 3     die Vorrichtung zur Kompensation des Erdschlusses in schematischer Form;

Figur 5     ein schematisches Ablaufdiagramm;

Figur 6     ein schematisches Zustands-Übergangs-Diagramm;

Figur 7     ein schematisches Verlagerungsspannung-Reststrom-Verstimmungs-Diagramm;

Figur 8     ein schematisches Spannungs-Induktivitäts-Zeit-Diagramm;

Figur 10     in schematischer Form ein Erdschluss-Ortungsverfahren; und

Figur 11     in schematischer Ansicht die Vorrichtung zur Kompensation eines Erdschlusses in einer alternativen Ausführungsform.

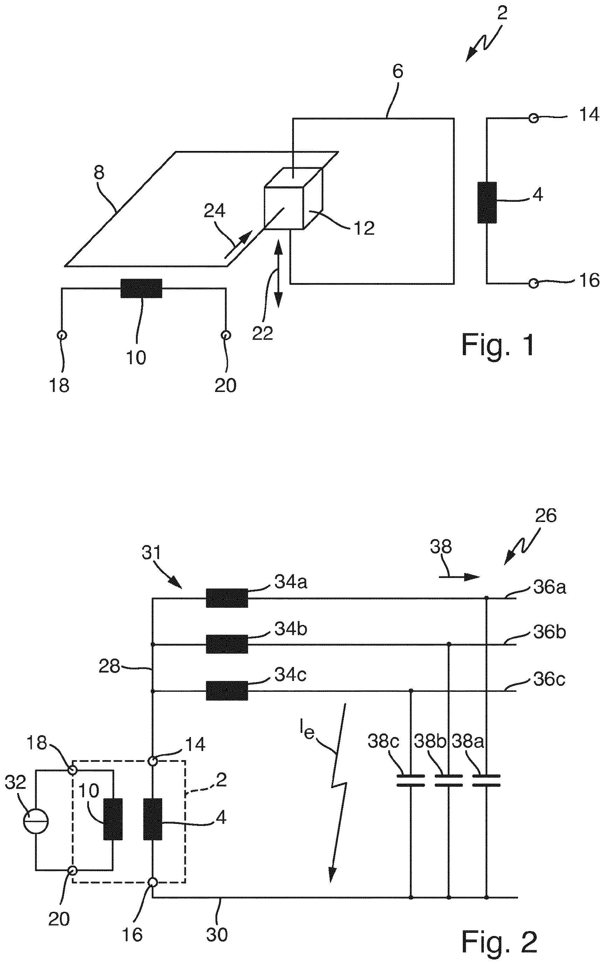

Figur 1 zeigt in schematischer Form eine Vorrichtung 2 zur Kompensation eines Erdschlusses in einem mehrphasigen Mittel- oder Hochspannungsnetz. Unter einem mehrphasigen Mittel- oder Hochspannungsnetz ist ein Wechselstromnetz der Mittel- oder Hochspannung zu verstehen. Die Vorrichtung 2 umfasst eine Kompensationswicklung 4 eines ersten magnetischen Kreises 6. Die Vorrichtung ist derart ausgebildet, dass mittels eines zweiten magnetischen Kreises 8 eine für das Wechselstromnetz wirksame Induktivität der Kompensationswicklung 4 einstellbar ist. Zur Einstellung der Induktivität der Kompensationswicklung 4 umfasst der zweite magnetische Kreis 8 eine Einstellwicklung 10, mittels derer eine wirksame Reluktanz des ersten magnetischen Kreises 6 einstellbar ist. Die Reluktanz wird auch als magnetischer Widerstand bezeichnet. Der erste magnetische Kreis 6 und der zweite magnetische Kreis 8 sind mittels eines ferromagnetischen Abschnitts 12 miteinander gekoppelt. Die Kompensationswicklung 4 hat zwei Anschlüsse 14 und 16. Die Einstellwicklung 10 hat Anschlüsse 18 und 20.

Die Kompensationswicklung 4 wird mit den Anschlüssen 14 und 16 zwischen einem Sternpunkt des Netzes und Erde angeordnet. Die Einstellwicklung 10 wird mit einer Stromquelle betrieben, wobei es sich bei der Stromquelle beispielsweise um eine dynamisch gesteuerte Gleichstromquelle oder um eine phasensynchrone Wechselstromquelle handeln kann, und wobei die Stromquelle einen Steuerstrom erzeugt. Die Stromquelle wird in Figur 2 näher erläutert. Mithin bildet sich im Erdschlussfall in dem ersten magnetischen Kreis 6 ein magnetisches Wechselfeld 22 aus. Nach einem entsprechenden Einschwingvorgang bildet sich nach dem Einschalten der mit der Einstellwicklung 10 verbundenen Stromquelle in dem zweiten magnetischen Kreis 8 ein im Wesentlichen konstantes Magnetfeld 24 aus. Selbstverständlich kann die Einstellwicklung 10 auch derart betrieben werden, dass sich ein veränderliches magnetisches Feld 24 in den zweiten magnetischen Kreis ausbildet.

Der Koppelabschnitt 12 umfasst weisssche Bezirke, die magnetisierbare Bereiche eines ferromagnetischen Stoffes sind. Die weissschen Bezirke sind nun sowohl von dem Magnetfeld 22 als auch von dem Magnetfeld 24 beeinflussbar. Erhöht man den Steuerstrom durch die Einstellwicklung 10, werden durch das stärkere Magnetfeld 24 eine erhöhte Anzahl von weissschen Bezirken in dem ersten magnetischen Kreis 6, insbesondere in dem Koppelabschnitt 12, gemäß dem Verlauf des Magnetfelds 24 beeinflusst. Die gemäß dem Magnetfeld 24 beeinflussten weissschen Bezirke des ersten magnetischen Kreises 6 ändern dadurch entsprechend ihre Ausrichtung und das Verhalten gegenüber dem Wechselfeld 22. Mithin steigt durch eine Erhöhung des Steuerstroms durch die Einstellspule 10 die resultierende Reluktanz in dem ersten magnetischen Kreis 6. Eine Steigerung des magnetischen Widerstands bzw. der Reluktanz in dem ersten magnetischen Kreis 6 hat zur Folge, dass die mit der Kompensationswicklung 4 verbundene Induktivität sinkt. Entsprechendes gilt für ein Herabsetzen der Reluktanz. Somit ergibt sich die Einstellbarkeit der mit der Kompensationswicklung 4 gekoppelten Induktivität mittels der Einstellbarkeit des zweiten magnetischen Kreises 8.

Figur 2 zeigt in schematischer Form, wie die Vorrichtung 2 zur Kompensation eines Erdschlusses in einem mehrphasigen Mittel- oder Hochspannungsnetz 26 anordenbar ist. Das gezeigte stark vereinfachte Ersatzschaltbild zeigt, wie die Vorrichtung 2 mit dem Anschluss 14 an einem Sternpunkt 28 eines Transformators 31, mit dem Anschluss 16 an Erde 30 und mit den Anschlüssen 18 und 20 an der Stromquelle 32 angeschlossen ist. Aus Übersichtsgründen sind nur die netzseitigen Wicklungen 34a, 34b und 34c des Transformators 31 gezeigt. Die netzseitigen Wicklungen 34 sind jeweiligen Phasen 36 zugeordnet. In Richtung des Pfeils 38 sind die Verbraucher des Netzes 26 angeordnet. Gemäß dem in Figur 2 gezeigten Ersatzschaltbild sind zwischen den einzelnen Phasen 36 und Erde 30 die Erdkapazitäten 38 dargestellt. Maßgebend für die Höhe eines Erdschlussstromes Ie ist der bestehende Parallelschwingkreis aus der Kompensationswicklung 4 und den Erdkapazitäten 38a und 38b der fehlerfreien Leiter. Die Fehlerstelle im gezeigten Ersatzschaltbild befindet sich somit zwischen der Phase 36c und Erde 30.

Das gezeigte Mittel- bzw. Hochspannungsnetz 26 stellt ein kompensiertes Netz dar, in dem beispielsweise Lichtbogen-Erdschlüsse selbstständig verlöschen. Mithin kann der Betrieb des Netzes 26 auch bei einem Dauer-Erdschluss aufrechterhalten werden. Bevorzugterweise wird das Netz überkompensiert betrieben, indem die Induktivität der Kompensationswicklung 4 kleiner gewählt wird als eine der Kapazität 30 entsprechende für den Parallelschwingkreis ideale Induktivität für die Kompensationswicklung 4. Mithin ist die Induktivität der Kompensationswicklung 4 mittels des zweiten magnetischen Kreises 8 derart einstellbar, so dass der Erdschlussstrom Ie mittels der Kompensationswicklung 4 im Wesentlichen kompensierbar ist.

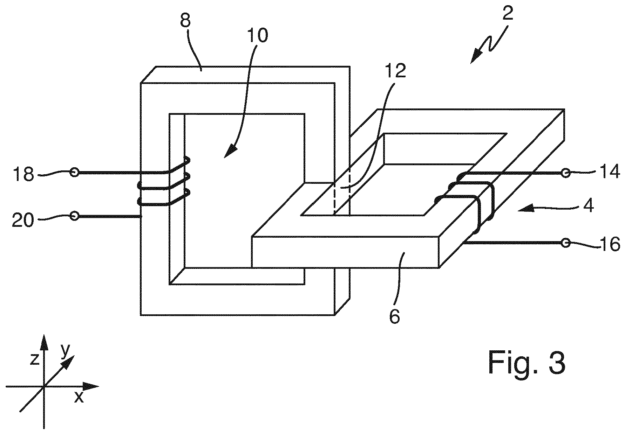

Figur 3 zeigt in schematischer dreidimensionaler Ansicht die Vorrichtung 2. Der zweite magnetische Kreis 8 ist zumindest im Bereich des Koppelabschnitts 12 im Wesentlichen in einer Lotebene des ersten magnetischen Kreises 6 durch den Koppelabschnitt 12 angeordnet. Durch diese Anordnung wird sichergestellt, dass das Magnetfeld des zweiten magnetischen Kreises 8, insbesondere in dem Koppelbereich 12, im Wesentlichen bzw. hauptsächlich orthogonal zu dem magnetischen Wechselfeld in dem ersten magnetischen Kreis 6 eingekoppelt wird. Vorliegend ist der erste magnetische Kreis 6 in einer xy-Ebene ausgerichtet und der zweite magnetische Kreis 8 ist in einer xz-Ebene ausgerichtet.

In Bezug auf die Figur 3 sollen im Folgenden weitere Ausführungsbeispiele der Anordnung des ersten und zweiten magnetischen Kreises 6, 8 zueinander erläutert werden. So können beispielsweise mehrere zweite magnetische Kreise 8 an dem ersten magnetischen Kreis 6 angeordnet werden.

Die Anordnung gemäß der Lotebene umfasst beispielsweise eine beliebige Drehung oder Anordnung des zweiten magnetischen Kreises 8 in einer xz-Ebene. Darüber hinaus umfasst die Anordnung des zweiten magnetischen Kreises 8 in der Lotebene des ersten magnetischen Kreises 6 durch den Koppelabschnitt 12 eine beliebige Drehung des in Figur 3 durch den Koppelbereich 12 verlaufenden und in z-Richtung verlaufenden Abschnitts des zweiten magnetischen Kreises 8 in der xz-Ebene. Die übrigen von dem vorgenannten Abschnitt abweichenden Bereiche des zweiten magnetischen Kreises 8 können hingegen beliebig orientiert sein, soweit die Funktion des zweiten magnetischen Kreises 8 aufrechterhalten wird.

Selbstverständlich kann einer der magnetischen Kreise 6 oder 8 auch eine Unterbrechung, beispielsweise in Form eines Luftspalts, aufweisen. Selbstverständlich kann einer der magnetischen Kreise 6 oder 8 auch mit einem Tauchkern ausgestattet sein. Selbstverständlich sind auch mehrschenklige Ausführungen der magnetischen Kreise 6 und 8 denkbar. Mithin wird explizit darauf verwiesen, dass von der Figur 3 abweichende Ausführungen denkbar sind, um die in dieser Beschreibung erläuterten Verfahren durchzuführen.

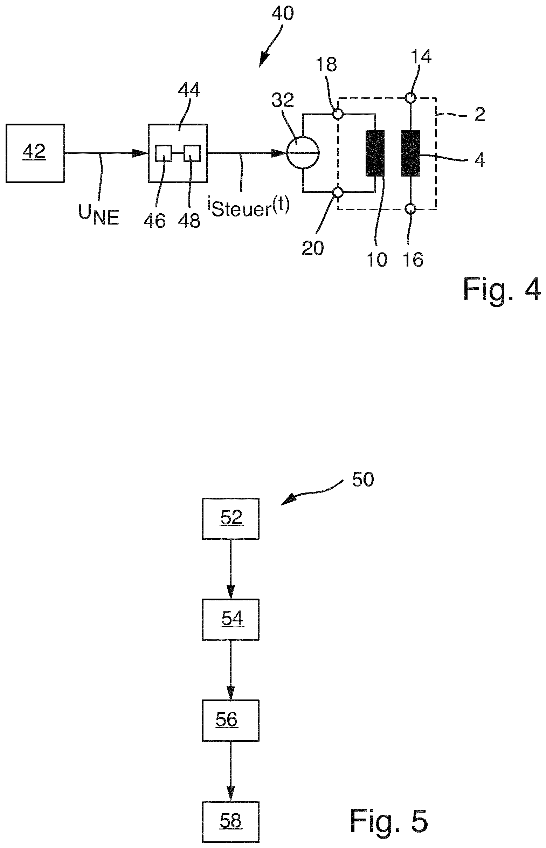

Figur 4 zeigt in schematischer Form eine weitere Vorrichtung 40 zur Kompensation eines Erdschlusses. Die Vorrichtung 40 umfasst die nach dem Transduktor-Prinzip arbeitende zuvor zu den Figuren 1 bis 3 erläuterte Vorrichtung 2. Selbstverständlich kann die Vorrichtung 2 parallel zu weiteren verstellbaren oder nicht-verstellbaren Induktivitäten geschaltet werden, um eine auf den Erdschlussfall abgestimmte Gesamtinduktivität bereitzustellen.

Ein Messglied 42 ist dazu ausgebildet, eine einen potentiellen Erdschluss charakterisierende Messgröße UNE, welche eine Verlagerungsspannung darstellt, zu ermitteln, wobei der potentielle Erdschluss bei der Ermittlung der Messgröße UNE noch nicht vorliegen muss. Die Messgröße UNE wird einer Recheneinheit 44 zugeführt, welche einen Prozessor 46 und ein mit dem Prozessor 46 verbundenes Speicherelement 48 umfasst. Auf dem Speicherelement 48 ist ein Computerprogramm abgespeichert, welches dazu ausgebildet ist, die hier beschriebenen Verfahrensschritte auszuführen. Des Weiteren können auf dem Speicherelement 48 ermittelte Messgrößen wie beispielsweise die Messgröße UNE abgespeichert werden. Selbstverständlich können andere oder weitere Messgrößen als die Messgröße UNE ausgewertet werden, um den potentiellen Erdschluss zu detektieren. Beispielsweise können die Phasen-Ströme und/oder Phasen-Spannungen des Feldes der Vorrichtung 2 oder weiterer Felder zur Ermittlung des potentiellen Erdschlusses herangezogen werden.

Ein Betriebsparameter iSteuer(t) der Einstellwicklung 10, welcher einen potentiell zeitvarianten Steuerstrom darstellt, wird in Abhängigkeit von der zumindest einen Messgröße UNE mittels der Recheneinheit 44 ermittelt, um die Kompensationswicklung 4 in einem Erdschluss-Betriebspunkt zu betreiben. Selbstverständlich können andere oder weitere Messgrößen als die Messgröße UNE ausgewertet werden, um den Betriebsparameter iSteuer(t) mittels Recheneinheit 44 zu ermitteln. Beispielsweise können die Phasen-Ströme und/oder Phasen-Spannungen des Feldes der Vorrichtung 2 oder weiterer Felder herangezogen werden. Die Ermittlung der Messgröße UNE und die Ermittlung des Betriebsparameters iSteuer(t) kann sowohl in einer ersten als auch in einer zweiten Betriebsart durchgeführt werden, wobei sich die erste Betriebsart dadurch gekennzeichnet, dass sich das Mittel- oder Hochspannungsnetz 26 in einem Normalbetrieb befindet, wobei in dem Normalbetrieb kein Erdschluss vorhanden ist.

Die Recheneinheit 44 ist dazu ausgebildet, einen Erdschlussfall in dem Mittel- oder Hochspannungsnetz 26 zu ermitteln oder aber es wird der Erdschlussfall in einer weiteren, nicht gezeigten Einheit ermittelt und der Recheneinheit 44 zugeführt. Tritt nun der Erdschlussfall ein, so wechselt die Vorrichtung 40 in eine zweite Betriebsart.

In der zweiten Betriebsart wird die Einstellwicklung 10 in Abhängigkeit von dem zumindest einen Betriebsparameter iSteuer(t) derart betrieben, sodass sich die Kompensationswicklung 4 in dem Erdschluss-Betriebspunkt befindet. Der Betriebsparameter iSteuer(t) wird der Stromquelle 32, insbesondere einer der Stromquelle 32 zugeordneten Leistungselektronik zugeführt. Der Betrieb der Kompensationswicklung 4 in dem Erdschluss-Betriebspunkt ermöglicht es, den durch einen Erdschluss erzeugten beispielsweise kapazitiven Strom durch den mittels der Kompensationswicklung 4 eingestellten gegenphasig fließenden beispielsweise induktiven Strom zu kompensieren und die Oberschwingungsströme zu minimieren.

Der Erdschluss-Betriebspunkt der Kompensationswicklung 4 umfasst somit zumindest ein Konstanthalten der wirksamen Induktivität in dem Erdschlussfall. Darüber hinaus kann der Erdschluss-Betriebspunkt auch eine zeitliche Variation der mittels der Kompensationswicklung 4 am Sternpunkt wirksamen Induktivität umfassen. Folglich wird der Erdschluss-Betriebspunkt durch den Betriebsparameter iSteuer(t), welcher optional ein zusätzliches Kompensationssignal zur Dämpfung von Oberschwingungen umfasst, bestimmt.

Figur 5 zeigt ein schematisches Ablaufdiagramm 50. In dem Schritt 52 wird mittels des Messgliedes 42 die zumindest eine den potentiellen Erdschluss charakterisierende Messgröße UNE ermittelt. In einem Schritt 54 wird der zumindest eine Betriebsparameter iSteuer(t) der Einstellwicklung 10 in Abhängigkeit von der zumindest einen Messgröße UNE mittels der Recheneinheit 44 ermittelt. In dem Schritt 54 erfolgt auch die Ermittlung des Kompensationssignals, welches neben einem Aufpunkt für die Einstellwicklung ein zeitvariantes Signal zur Kompensation von Oberschwindungen bereitstellt. In einem Schritt 56 wird der Erdschlussfall in dem Mittel- oder Hochspannungsnetz 26 mittels der Recheneinheit 44 ermittelt. In einem Schritt 58 wird, wenn der Erdschlussfall ermittelt wird, mittels der Gleichstromquelle 32 die Einstellwicklung 10 in Abhängigkeit von dem zumindest einen Betriebsparameter iSteuer(t), welches das Kompensationssignal umfasst, derart betrieben, sodass sich die Kompensationswicklung 4 in dem Erdschluss-Betriebspunkt befindet.

Selbstverständlich lassen sich mit der Gleichstromquelle 32 auch veränderliche Ströme auf die Einstellwicklung einprägen. Dies ist für die in dieser Beschreibung offenbarten Verfahren teilweise unerlässlich. Es sei hierbei auf die nachfolgenden Ausführungen zu dem Kompensationssignal verwiesen. D. h. die Gleichstromquelle 32 kann auch Wechselströme erzeugen, weshalb sie allgemein auch als Stromquelle bezeichenbar ist.

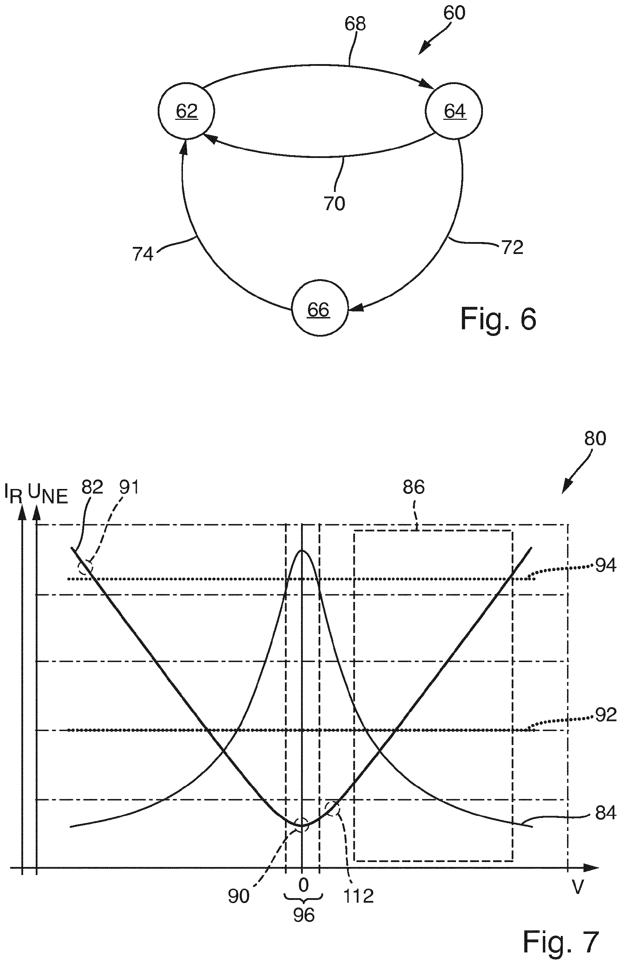

Figur 6 zeigt ein schematisches Zustands-Übergangs-Diagramm 60. Neben der ersten Betriebsart 62 und der zweiten Betriebsart 64 ist eine dritte Betriebsart 66 gezeigt. In der ersten Betriebsart 62 befindet sich das Mittel- oder Hochspannungsnetz 26 in einem Normalbetrieb ohne Erdschluss. In dem Erdschlussfall 68 wechselt die Vorrichtung 40 in die zweite Betriebsart 64, um den Erdschluss zu kompensieren.

Wird beispielsweise unter Zuhilfenahme weiterer Messgrößen festgestellt, dass der Erdschluss selbstständig erloschen ist, was beispielsweise bei einem Blitzeinschlag im Bereich einer Freileitung vorkommt, so wird in diesem Selbstlöschungsfall 70 zurück in die erste Betriebsart 62 gewechselt. Wird in der zweiten Betriebsart 64 jedoch festgestellt, dass es zu keiner Selbstlöschung kommt, wird von einem permanenten Erdschluss, wie es beispielsweise bei einem Baggerangriff an eine Phase einer Erdleitung vorkommen kann, so wird ausgehend von der zweiten Betriebsart 64 in einem Permanenterdschlussfall 72 in die dritte Betriebsart 66 gewechselt.

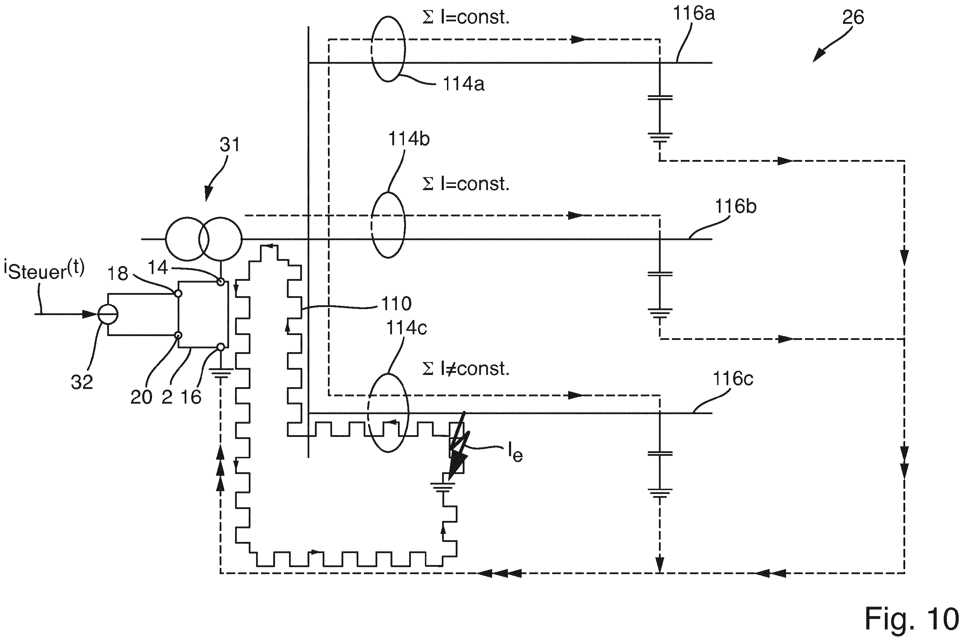

In der dritten Betriebsart 66 wird eine Erdschlussortung durchgeführt, was in Figur 10 näher erläutert ist. Kann in der dritten Betriebsart 66 die Erdschlussortung erfolgreich durchgeführt werden und kommt es beispielsweise aufgrund der Erdschlussortung zu einer erfolgreichen Behebung des Erdschlusses, so wird in einem Behebungsfall 74 zurück in die erste Betriebsart 62 gewechselt.

Figur 7 zeigt ein schematisches Verlagerungsspannung-Reststrom-Verstimmungs-Diagramm 80. Ein Verlauf 82 eines Betrags eines Erdschluss-Reststromes IR sowie ein Verlauf 84 der Messgröße UNE in Form der Verlagerungsspannung sind über einer Verstimmung V aufgetragen. Die Verstimmung V betrifft ein Verhältnis zwischen dem Grundschwingungs-Blindstromanteil des Erdschluss-Reststroms IR und dem an der Erdschlussstelle wirksamen kapazitiven Strom. Für einen Wert von V gleich Null liegt eine ideale Kompensation des Erdschlusses vor. Für V kleiner Null ist das Mittel- oder Hochspannungsnetz 26 überkompensiert. Für V größer 0 ist das Mittel- oder Hochspannungsnetz 26 unterkompensiert. Es ist in Figur 7 der Fall des Hochspannungsnetzes 26 gezeigt, der sich von dem Fall eines Mittelspannungsnetzes durch die hohe Verlagerungsspannung im Bereich der Verstimmung von Null unterscheidet. Davon abgesehen lässt sich der in Figur 7 erläuterte Betrieb ohne weiteres auch auf das Mittelspannungsnetz 26 übertragen.

Der Betrag des Erdschluss-Reststroms IR ergibt sich nach der nachfolgenden Gleichung 1:

$$|I_R| = \sqrt{I_{wr}^2 + (I_L - I_{CE})^2 + \sum_v I_v^2 + I_u} \qquad (1)$$

Ein Wirkreststrom IWR ergibt sich aus den ohmschen Verlusten bei einem einpoligen Erdschluss. Der Spulenstrom IL ist der induktive Erdschlussstrom und der kapazitive Erdschlussstrom ist mit ICE gekennzeichnet. Mit Iv sind die Oberschwingungsanteile des Erdschlussstromes gekennzeichnet. Des Weiteren ergibt sich im Erdschlussfall ein Unsymmetriestrom Iu.

In Abhängigkeit von der den potentiellen Erdschluss charakterisierenden Messgröße UNE wird in der ersten Betriebsart 62 der Betriebsparameter iSteuer(t) derart ermittelt, dass die Kompensationswicklung 4 in einem Erdschluss-Betriebspunkt 90 betreibbar ist. Der Erdschluss-Betriebspunkt 90 ist insbesondere als idealer Betriebspunkt bezeichenbar, da hier der Erdschluss-Reststroms IR minimal wird. Insbesondere wird in dem Erdschluss-Betriebspunkt 90 der Term IL-ICE minimiert bzw. geht gegen Null. In der ersten Betriebsart 62 wird die Kompensationswicklung 4 beispielsweise in einem Normal-Betriebspunkt 91 betrieben, so dass sich die Einstellwicklung im stromlosen Zustand befindet.

Beispielhaft ist ein Betriebsbereich 86 einer Tauchkernspule nach dem Stand der Technik und unter Berücksichtigung eines maximalen Erdschluss-Reststroms IR gezeigt. In diesem Betriebsbereich 86 stellt sich die Tauchkernspule selbstständig auf eine entsprechende Induktivität ein, welche im Fall des Erdschlusses eine Kompensation bewirkt. Tritt nun der Erdschlussfall ein, so wird die Induktivität der Tauchkernspule ausgehend von dem Normalbetrieb nicht verändert. Darüber hinaus lässt sich mit der Tauchkernspule nach dem Stand der Technik der Erdschluss-Betriebspunkt 90 in der ersten Betriebsart 62 nicht erreichen.

In der ersten Betriebsart 62 der Vorrichtung 40, d.h. während des Normalbetriebs des Mittel- oder Hochspannungsnetzes 26, wird die Induktivität der Kompensationswicklung 4 kurzzeitig verändert und die Verlagerungsspannung im Sinne der Messgröße UNE ausgewertet. In Abhängigkeit von der Verlagerungsspannung wird der Betriebspunkt 90 ermittelt. Selbstverständlich können auch weitere Messgrößen zur Ermittlung des Erdschluss-Betriebspunkts 90 verwendet werden.

In dem Hochspannungsnetz 26 ergibt sich aufgrund Asymmetrien im Netz bzw. aufgrund Beeinflussung anderer Energieversorgungsnetze, d.h. aufgrund unterschiedlicher Leiter-Erd-Kapazitäten und aufgrund von parallel geführten Leitungen, ein hohes Verlagerungsspannungs-Maximum. Deshalb darf eine erste Schwelle 92 für die Verlagerungsspannung nicht dauerhaft überschritten werden. Es ist jedoch möglich, die erste Schwelle 92 kurzzeitig zu Messzwecken zu überschreiten, wobei eine zweite Schwelle 94 auch kurzzeitig nicht überschritten werden darf. Damit ergibt sich ein Bereich 96 der Verstimmung V um V gleich Null herum, in welchem das Hochspannungsnetz 26 in seinem Normalbetrieb auch kurzzeitig nicht betrieben werden darf. Mithin ergibt sich insbesondere für eine Tauchkernspule, dass diese aufgrund ihrer im Wesentlichen festen bzw. nicht dynamisch veränderbaren Induktivität nicht in dem Betriebspunkt 90 betrieben werden darf.

Die Vorrichtung 40 hingegen erlaubt es, das Hochspannungsnetz 26 in der ersten Betriebsart 62 unbestromt zu betreiben und anschließend in einem Erdschlussfall durch eine Bestromung der Einstellwicklung 10 den vorab ermittelten Erdschluss-Betriebspunkt 90 anzufahren und in dem Betriebspunkt 90 durch einen zeitvarianten Betriebsparameter für die Einstellwicklung 10 Oberschwingungen zu dämpfen . Selbstverständlich lässt sich das Anfahren des Erdschluss-Betriebspunktes 90 auch auf den Fall eines Mittelspannungsnetzes 26 übertragen.

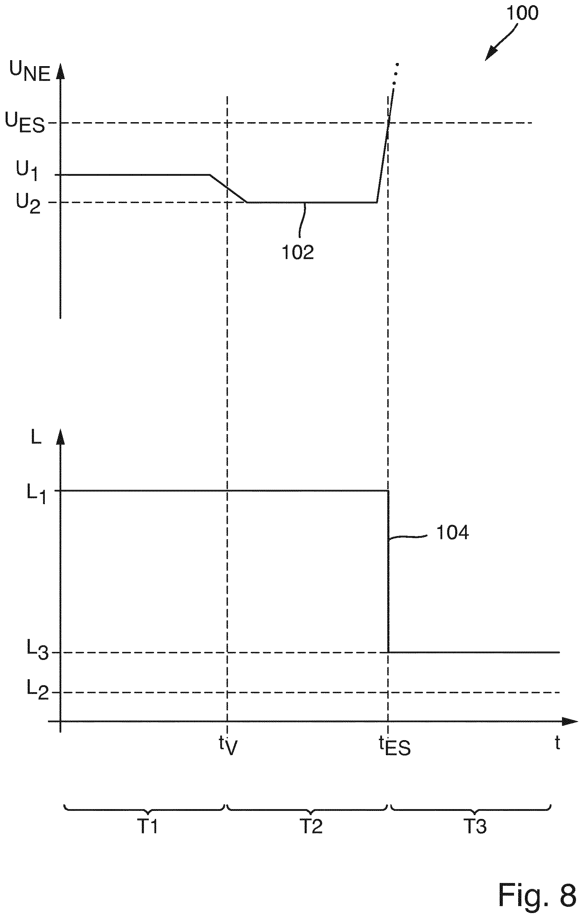

Figur 8 zeigt ein schematisches Spannungs-Induktivitäts-Zeit-Diagramm 100. In einem ersten Zeitraum T1 befindet sich die Messgröße UNE gemäß einem Verlauf 102 auf einem ersten Niveau U1, um aufgrund einer Änderung in dem Mittel-oder Hochspannungsnetz 26 zu einem Zeitpunkt tV auf ein zweites Spannungsniveau U2 abzusinken. Mithin wird zu dem Zeitpunkt tV in der ersten Betriebsart 62 eine Veränderung in dem Mittel- oder Hochspannungsnetz ermittelt.

Während der ersten Betriebsart wird für die Kompensationswicklung 4 eine erste Induktivität L1 gemäß einem Verlauf 104 vorgegeben und die Vorrichtung 40 entsprechend betrieben. Zur Vorgabe der ersten Induktivität L1 kann die Einstellwicklung 10 auch unbestromt sein. Selbstverständlich ist aber auch eine Bestromung der Einstellwicklung 10 zum Erreichen der Induktivität L1 denkbar.

Des Weiteren wird während der ersten Betriebsart in dem ersten Zeitraum T1 eine zweite Induktivität L2 für den Erdschlussfall 68 in Abhängigkeit von der Messgröße UNE oder in Abhängigkeit von einer weiteren Messgröße ermittelt. Wenn die vorgenannte Veränderung zu dem Zeitpunkt tV festgestellt wird, wird in einem auf den ersten Zeitraum T1 folgenden Zeitraum T2 eine dritte Induktivität L3 für den Erdschlussfall ermittelt. Im zweiten Zeitraum T2 verweilt die Kompensationswicklung 4 bei der ersten Induktivität L1.

Der Erdschlussfall 68 wird zu einem Zeitpunkt tES ermittelt und die Vorrichtung 40 wird derart betrieben, dass in der zweiten Betriebsart 64 die Kompensationswicklung 4 gemäß dem Verlauf 104 auf die dritte Induktivität L3 eingestellt wird. Mithin findet in einem dritten Zeitraum T3 eine Kompensation des Erdschlusses statt. Die Veränderung der Induktivität L1 der Kompensationswicklung 4 hin zu der Induktivität L3 ist Teil einer Veränderung des Betriebspunktes zu dem Zeitpunkt tES. Weitergehend kann die Induktivität L3 in dem Zeitraum T3 zeitlich verändert werden, um beispielsweise Oberschwingungen zu dämpfen.

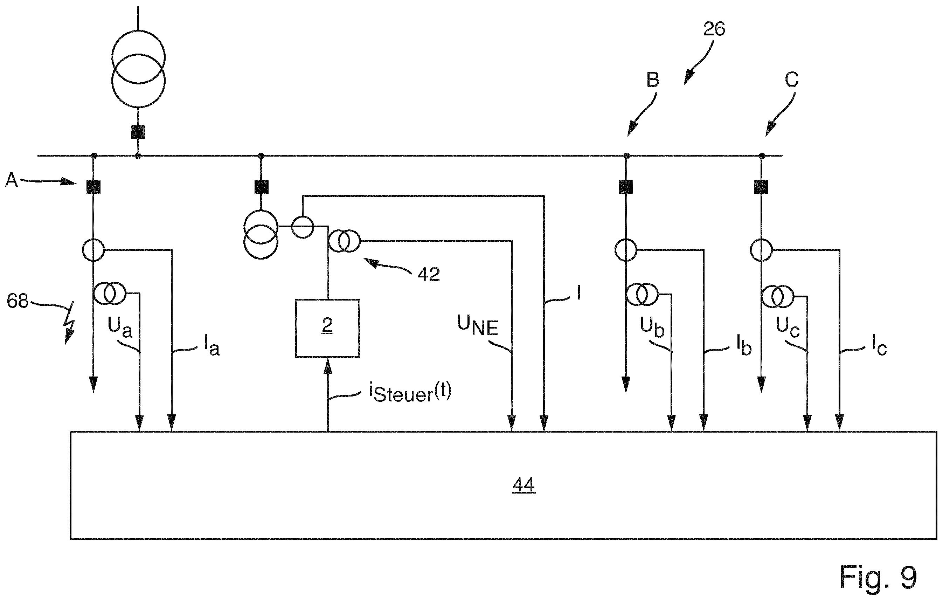

Figur 9 zeigt in einer Ausführungsform das Mittel- oder Hochspannungsnetz 26, wobei die Vorrichtung 40 schematisch mittels der Vorrichtung 2, der Recheneinheit 44 und dem Messglied 42 repräsentiert wird. Es sind Abzweige A, B und C gezeigt, bei denen jeweilige Ströme I und Spannungen U gemessen und der Recheneinheit 44 zur Verfügung gestellt werden. Tritt nun der Erdschlussfall 68 in dem Abzweig A ein, so ermittelt die Recheneinheit 44 aus den zugeführten Größen eine oder mehrere Oberschwingungen des Erdfehlerstroms, wobei die Oberschwingungen gemäß der Gleichung 1 durch den Term $\sum_v I_v^2$ repräsentiert werden. Die Recheneinheit 44 ermittelt ein zu der jeweiligen Oberschwingung gegenphasiges Kompensationssignal im Sinne eines weiteren Betriebsparameters. Entsprechend der Anzahl der detektierten Oberschwingungen wird eine Anzahl von gegenphasigen Kompensationssignalen ermittelt. Ein jeweiliges der gegenphasigen Kompensationssignale umfasst eine entsprechende Frequenz im Sinne eines Vielfachen der Netzfrequenz, eine Amplitude und eine Phase. Diese Parameter des jeweiligen Kompensationssignals werden von der Recheneinheit 44 mittels eines geeigneten Reglermodells ermittelt.

Unter dem gegenphasigen Kompensationssignal wird ein Signal verstanden, welches, über den entsprechenden Betrieb der Einstellwicklung 10 in das Mittel- oder Hochspannungsnetz eingebracht, eine gegenphasige Wirkung auf die zu reduzierende Oberschwingung hat. Folglich können sich Frequenzen und Phasen des Kompensationssignals und der zu reduzierenden Oberschwingung unterscheiden.

Die gegenphasigen Kompensationssignale werden in ein entsprechendes Stromsignal gewandelt und können damit zu dem bereits ermittelten Betriebsparameter iSteuer(t) hinzuaddiert werden. Die Recheneinheit 44 betreibt damit die Einstellwicklung 10 mittels der Gleichstromquelle 32 in Abhängigkeit von dem zumindest einen Betriebsparameter UNE und dem Kompensationssignal derart, sodass die Kompensationswicklung 4 in dem Erdschluss-Betriebspunkt 90 eine Amplitude der Oberschwingung des Fehlerstroms reduziert. Der Erdschluss-Betriebspunkt 90 umfasst damit eine Einstellung einer zeitvarianten Induktivität der Kompensationswicklung 4, wobei diese Induktivität Frequenzanteile mit einem mehrfachen der Netzfrequenz des Mittel-oder Hochspannungsnetzes 26 umfasst. Selbstverständlich kann die Kompensationswicklung 4 auch in Abhängigkeit von den Netzgrößen Ua bis Uc und/oder Ia bis Ic ohne Berücksichtigung des Betriebsparameters UNE ermittelt werden.

Durch eine den Betrieb der Einstellwicklung 10 mithilfe des Kompensationssignals werden Oberschwingungsströme im Erdschlussreststrom gedämpft.

Wird eine sinusförmige Wechselspannung angesetzt, so ergibt sich der Spulenstrom beispielsweise nach Gleichung 2.

$$i_L = -\left[\frac{1}{L} \cdot U \cdot cos(\omega t)\right] + Restterm \qquad (2)$$

Die Funktion 1/L wird so gewählt, dass sich einzelne Harmonische im Sinne der Amplitudenmodulation gezielt erzeugen lassen. Wählt man beispielsweise einen kosinusförmigen Verlauf, so lässt sich gemäß dem Additionstheorem eine Kombination einzelner Frequenzanteile nach Gleichung 3 gezielt erzeugen.

$$cos\,x \cdot cos\,y - \frac{1}{2} \cdot (cos(x-y) + cos(x+y)) \qquad (3)$$

Soll der Spulenstrom beispielsweise Anteile der dritten und fünften Harmonischen aufweisen, ergibt sich unter Berücksichtigung einer stationären Induktivität L1, d. h. für einen Grundschwingungsanteil, eine Modulationsfunktion nach Gleichung 4. Folglich werden mit einem Kompensationssignal mit einer ersten Frequenz Störschwingungen zweiter Frequenzen gedämpft.

$$\frac{1}{L} = \frac{1}{L_1} + A_4 \cdot cos(4\omega t - \varphi_4) \qquad (4)$$

Der Steuerstrom iSteuer(t) umfasst einen Gleichstromanteil iDC sowie das Kompensationssignal zum Betrieb der Einstellwicklung 10 und ergibt sich nach Gleichung 5. Das Kompensationssignal ist rechterhand von dem Gleichstromanteil iDC gezeigt.

$$iSteuer(t) = i_{DC} + \sum_{i=1}^{n} A_i \cdot cos(i\omega t - \varphi_i) \qquad (5)$$

Figur 10 zeigt in schematischer Form ein Erdschluss-Ortungsverfahren, welches mittels der Vorrichtung 40 ausgeführt wird. Vorliegend wird der Betriebsparameter iSteuer(t) derart variiert, dass sich ein Pulsmuster 110 in dem Mittel- oder Hochspannungsnetz 26 ausbildet. In Figur 7 entspräche dies einem periodischen Abweichen von dem idealen Erdschluss-Betriebspunkt 90, in welchem der Reststrom IR minimiert wird, und einem kurzfristigen Einstellen eines Puls-Betriebspunkts 112. Damit wird in der dritten Betriebsart 66 die Einstellwicklung 10 mittels eines entsprechenden zeitvarianten Betriebsparameters iSteuer(t) derart betrieben, dass ein periodischer Wechsel zwischen dem Erdschluss-Betriebspunkt 90 und dem Puls-Betriebspunkt 112 stattfindet.

An jedem der Abzweige 116a, 116b und 116c befindet sich ein entsprechender Messpunkt 114a, 114b und 114c. In dem Abzweig 116c wird an dem Messpunkt 114c festgestellt, dass die Summe aller Phasenströme aufgrund des ausgeprägten Pulsmusters 110 nicht konstant ist, womit der Abzweig 116c den Erdschluss umfasst. Die Messstelle 114c übermittelt diese Abweichung beispielsweise an die Vorrichtung 4 oder eine übergeordnete Meldestelle, womit eine Fehlerortung und -meldung durchgeführt ist.

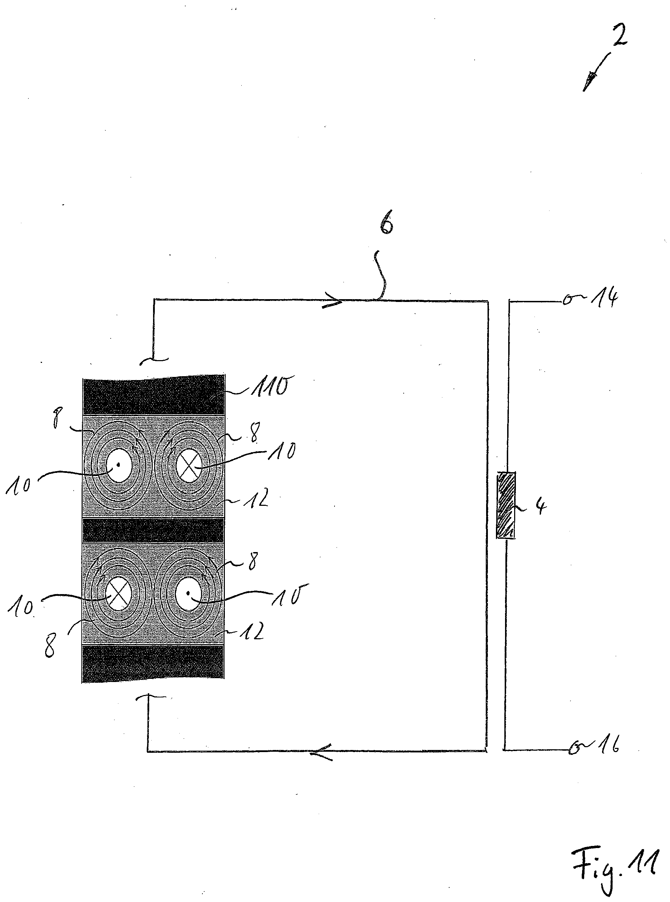

Figur 11 zeigt in schematischer Ansicht die Vorrichtung 2 in einer alternativen Ausführungsform. Zweite magnetische Kreise 8 verlaufen innerhalb des ersten magnetischen Kreises 6 durch jeweilige Koppelabschnitte 12. Die zweiten magnetischen Kreise 8 werden mithilfe von durch ein Kernmaterial 110 des ersten magnetischen Kreises 8 geführten Einstellwicklungen 10 erzeugt und bewirken einen virtuellen, einstellbaren Luftspalt in Bezug zu dem ersten magnetischen Kreis 6. Das Kernmaterial 110 ist mit dem Magnetkreis 6 Bestandteil der Induktivität 4, es gibt also nur einen Eisenkern. Damit ist mittels der Einstellwicklung 10 eines jeweiligen magnetischen Kreises die Induktivität der Kompensationswicklung 4 einstellbar.

**Patentansprüche**

**1.** Ein Verfahren zum Betreiben einer Vorrichtung (40) zur Kompensation eines Erdschlusses in einem mehrphasigen Mittel- oder Hochspannungsnetz (26) mit einer Kompensationswicklung (4) eines ersten magnetischen Kreises (8), wobei mittels einer Einstellwicklung (10) eines zweiten magnetischen Kreises (8) eine Induktivität der Kompensationswicklung (4) einstellbar ist, und wobei der erste magnetische Kreis (6) und der zweite magnetische Kreis (8) mittels eines ferromagnetischen Abschnitts (12) miteinander gekoppelt sind, wobei

- zumindest eine einen potentiellen Erdschluss charakterisierende Messgröße (UNE) ermittelt wird,
- zumindest ein Betriebsparameter (iSteuer(t)) der Einstellwicklung (10) in Abhängigkeit von der zumindest einen Messgröße (UNE) ermittelt wird, wobei der zumindest eine Betriebsparameter (iSteuer(t)) derart ermittelt wird, um die Kompensationswicklung (4) in einem Erdschluss-Betriebspunkt (90) zu betreiben, und
- ein Erdschlussfall (68) in dem Mittel- oder Hochspannungsnetz (26) ermittelt wird, **dadurch gekennzeichnet,**
- **dass** eine Oberschwingung eines Erdschlussstromes (Ie) ermittelt wird,
- **dass** ein zu der Oberschwingung gegenphasiges Kompensationssignal ermittelt wird, und
- **dass** die Einstellwicklung (10) in Abhängigkeit von dem zumindest einen Betriebsparameter (iSteuer(t)) und dem Kompensationssignal derart betrieben wird, so dass die Kompensationswicklung (4) in dem Erdschluss-Betriebspunkt (90) eine Amplitude der Oberschwingung des Erdschlussstromes (Ie) reduziert.

2. Das Verfahren nach dem Anspruch 1,

- wobei, wenn der Erdschlussfall (68) ermittelt wird, die Einstellwicklung (10) in Abhängigkeit von dem zumindest einen Betriebsparameter (iSteuer(t)) derart betrieben wird, so dass sich die Kompensationswicklung (4) in dem Erdschluss-Betriebspunkt (90) befindet.

3. Das Verfahren nach dem Anspruch 2, wobei der Betriebsparameter (iSteuer(t)) der Einstellwicklung (10) während einer ersten Betriebsart (62) vor der Ermittlung des Erdschlussfalls (68) ermittelt wird.

4. Das Verfahren nach dem Anspruch 2 oder 3, wobei der Betriebsparameter (iSteuer(t)) der Einstellwicklung (10) während der zweiten Betriebsart (64) nach der Ermittlung des Erdschlussfalls (68) ermittelt wird.

5. Das Verfahren nach dem Anspruch 1,

- wobei die Oberschwingung des Erdschlussstromes (Ie) während der ersten Betriebsart (62) ermittelt wird.

6. Das Verfahren nach dem Anspruch 1,

- wobei die Oberschwingung des Erdschlussstromes (Ie) während der zweiten Betriebsart (64) ermittelt wird.

7. Das Verfahren nach einem der vorstehenden Ansprüche, wobei in der ersten Betriebsart (62) eine Veränderung in dem Mittel- oder Hochspannungsnetz (26) ermittelt wird, und wobei der zumindest eine Betriebsparameter (iSteuer(t)) aktualisiert wird, wenn die Veränderung ermittelt wird.

8. Das Verfahren nach einem der vorstehenden Ansprüche,

- wobei in der ersten Betriebsart (62) die Einstellwicklung (10) unbestromt ist.

9. Das Verfahren nach einem der vorstehenden Ansprüche,

- wobei, wenn der Erdschlussfall (68) ermittelt wird, die Einstellwicklung (10) in Abhängigkeit von dem zumindest einen Betriebsparameter (iSteuer(t)) derart betrieben wird, so dass der vorab ermittelte Erdschluss-Betriebspunkt (90) angefahren wird.

10. Eine Vorrichtung (40) zur Kompensation eines Erdschlusses in einem mehrphasigen Mittel- oder Hochspannungsnetz (26) mit einer Kompensationswicklung (4) eines ersten magnetischen Kreises (8), wobei mittels einer Einstellwicklung (10) eines zweiten magnetischen Kreises (8) eine Induktivität der Kompensationswicklung (4) einstellbar ist, wobei der erste magnetische Kreis (6) und der zweite magnetische Kreis (8) mittels eines ferromagnetischen Abschnitts (12) miteinander gekoppelt sind, wobei die Vorrichtung weiterhin umfasst:

- Mittel (42), um zumindest eine einen potentiellen Erdschluss charakterisierende Messgröße (UNE) zu ermitteln,
- Mittel (44), um zumindest einen Betriebsparameter (iSteuer(t)) der Einstellwicklung (10) in Abhängigkeit von der zumindest einen Messgröße (UNE) zu ermitteln, wobei der zumindest eine Betriebsparameter (iSteuer(t)) derart ermittelt wird, um die Kompensationswicklung (4) in einem Erdschluss-Betriebspunkt (90) zu betreiben,
- Mittel (44), um einen Erdschlussfall (68) in dem Mittel- oder Hochspannungsnetz (26) zu ermitteln, **dadurch gekennzeichnet, dass** die Vorrichtung weiterhin umfasst
- Mittel, um eine Oberschwingung eines Erdschlussstromes (Ie) zu ermitteln,
- Mittel, um ein zu der Oberschwingung gegenphasiges Kompensationssignal zu ermitteln, und
- Mittel, um die Einstellwicklung (10) in Abhängigkeit von dem zumindest einen Betriebsparameter (iSteuer(t)) und dem Kompensationssignal derart zu betreiben, sodass die Kompensationswicklung (4) in dem Erdschluss-Betriebspunkt (90) eine Amplitude der Oberschwingung des Erdschlussstromes (Ie) reduziert.

11. Die Vorrichtung (40) nach dem Anspruch 10 umfassend:

- Mittel (44), um, wenn der Erdschlussfall (68) ermittelt wird, die Einstellwicklung (10) in Abhängigkeit von dem zumindest einen Betriebsparameter (iSteuer(t)) derart zu betreiben, so dass sich die Kompensationswicklung (4) in dem Erdschluss-Betriebspunkt (90) befindet.

12. Die Vorrichtung (40) nach dem Anspruch 10 oder 11, welche dazu ausgebildet ist, das Verfahren nach einem der Ansprüche 2 bis 9 auszuführen.

**Claims**

1. A method for operating a device (40) for compensating for a ground fault in a multiphase medium or high voltage network (26) by means of a compensation winding (4) of a first magnetic circuit (8), an inductance of the compensation winding (4) being adjustable by means of an adjusting winding (10) of a second magnetic circuit (8), and the first magnetic circuit (6) and the second magnetic circuit (8) being coupled to one another by means of a ferromagnetic portion (12),

   - at least one measured variable (UNE) characterizing a potential ground fault being determined,
   - at least one operating parameter (iSteuer(t)) of the adjusting winding (10) being determined depending on the at least one measured variable (UNE), the at least one operating parameter (iSteuer(t)) being determined in such a way as to operate the compensation winding (4) at a ground fault operating point (90), and
   - a ground fault event (68) in the medium or high voltage network (26) being determined, **characterized in that**
   - a harmonic of a ground fault current (Ie) is determined,
   - a compensation signal in phase opposition to the harmonic is determined, and
   - the adjusting winding (10) is operated depending on the at least one operating parameter (iSteuer(t)) and the compensation signal such that the compensation winding (4) at the ground fault operating point (90) reduces an amplitude of the harmonic of the ground fault current (Ie) .

2. The method according to claim 1,

   - wherein, when the ground fault event (68) is determined, the adjusting winding (10) is operated depending on the at least one operating parameter (iSteuer(t)) such that the compensation winding (4) is at the ground fault operating point (90).

3. The method according to claim 2, wherein the operating parameter (iSteuer(t)) of the adjusting winding (10) is determined during a first operating mode (62) before the ground fault event (68) is determined.

4. The method according to claim 2 or claim 3, wherein the operating parameter (iSteuer(t)) of the adjusting winding (10) is determined during the second operating mode (64) after the ground fault event (68) has been determined.

5. The method according to claim 1,

   - wherein the harmonic of the ground fault current (Ie) is determined during the first operating mode (62).

6. The method according to claim 1,

   - wherein the harmonic of the ground fault current (Ie) is determined during the second operating mode (64).

7. The method according to any of the preceding claims, wherein in the first operating mode (62) a change in the medium or high voltage network (26) is determined, and wherein the at least one operating parameter (iSteuer(t)) is updated when the change is determined.

8. The method according to any of the preceding claims,

- wherein in the first operating mode (62) the adjusting winding (10) is de-energized.

9. The method according to any of the preceding claims,

- wherein, when the ground fault event (68) is determined, the adjusting winding (10) is operated depending on the at least one operating parameter (iSteuer(t)) such that the previously determined ground fault operating point (90) is approached.

10. A device (40) for compensating for a ground fault in a multiphase medium or high voltage network (26) by means of a compensation winding (4) of a first magnetic circuit (8), an inductance of the compensation winding (4) being adjustable by means of an adjusting winding (10) of a second magnetic circuit (8), the first magnetic circuit (6) and the second magnetic circuit (8) being coupled to one another by means of a ferromagnetic portion (12), the device further comprising:

- means (42) for determining at least one measured variable (UNE) characterizing a potential ground fault,
- means (44) for determining at least one operating parameter (iSteuer(t)) of the adjusting winding (10) depending on the at least one measured variable (UNE), the at least one operating parameter (iSteuer(t)) being determined in such a way as to operate the compensation winding (4) at a ground fault operating point (90),
- means (44) for determining a ground fault event (68) in the medium or high voltage network (26), **characterized in that** the device further comprises
- means for determining a harmonic of a ground fault current (Ie),
- means for determining a compensation signal in phase opposition to the harmonic, and
- means for operating the adjusting winding (10) depending on the at least one operating parameter (iSteuer(t)) and the compensation signal such that the compensation winding (4) at the ground fault operating point (90) reduces an amplitude of the harmonic of the ground fault current (Ie).

11. The device (40) according to claim 10, comprising:

- means (44) for operating the adjusting winding (10), when the ground fault event (68) is determined, depending on the at least one operating parameter (iSteuer(t)) such that the compensation winding (4) is at the ground fault operating point (90).

12. The device (40) according to claim 10 or claim 11, which is designed for carrying out the method according to any of claims 2 to 9.

**Revendications**

1. Procédé destiné à faire fonctionner un dispositif (40) de compensation d'un défaut à la terre dans un réseau polyphasé moyenne ou haute tension (26), comprenant un enroulement de compensation (4) d'un premier circuit magnétique (8), dans lequel une inductance de l'enroulement de compensation (4) est réglable au moyen d'un enroulement de réglage (10) d'un deuxième circuit magnétique (8), et dans lequel le premier circuit magnétique (6) et le deuxième circuit magnétique (8) sont couplés l'un à l'autre au moyen d'une section ferromagnétique (12), dans lequel

- au moins une grandeur de mesure (UNE) caractérisant un défaut à la terre potentiel est déterminée,
- au moins un paramètre de fonctionnement (iSteuer(t)) de l'enroulement de réglage (10) est déterminé en fonction de ladite au moins une grandeur de mesure (UNE), dans lequel ledit au moins un paramètre de fonctionnement (iSteuer(t)) est déterminé de manière pour faire fonctionner l'enroulement de compensation (4) sur un point de fonctionnement de défaut à la terre (90), et
- un cas de défaut à la terre (68) dans le réseau moyenne ou haute tension (26) est déterminé, **caractérisé par le fait**
- **qu'**une harmonique d'un courant de défaut à la terre (Ie) est déterminée,

- **qu'**un signal de compensation en opposition de phase avec l'harmonique est déterminé, et
- **que** l'enroulement de réglage (10) est opéré en fonction dudit au moins un paramètre de fonctionnement (iSteuer (t)) et du signal de compensation de telle sorte que, sur le point de fonctionnement de défaut à la terre (90), l'enroulement de compensation (4) réduit une amplitude de l'harmonique du courant de défaut à la terre (Ie) .

2. Procédé selon la revendication 1,

- dans lequel, lorsque le cas de défaut à la terre (68) est déterminé, l'enroulement de réglage (10) est opéré en fonction dudit au moins un paramètre de fonctionnement (iSteuer (t)) de telle sorte que l'enroulement de compensation (4) se trouve sur le point de fonctionnement de défaut à la terre (90).

3. Procédé selon la revendication 2, dans lequel le paramètre de fonctionnement (iSteuer (t)) de l'enroulement de réglage (10) est déterminé pendant un premier mode de fonctionnement (62) avant que le cas de défaut à la terre (68) soit déterminé.

4. Procédé selon la revendication 2 ou 3, dans lequel le paramètre de fonctionnement (iSteuer (t)) de l'enroulement de réglage (10) est déterminé pendant le deuxième mode de fonctionnement (64) après avoir déterminé le cas de défaut à la terre (68).

5. Procédé selon la revendication 1,

- dans lequel l'harmonique du courant de défaut à la terre (Ie) est déterminée lors du premier mode de fonctionnement (62).

6. Procédé selon la revendication 1,

- dans lequel l'harmonique du courant de défaut à la terre (Ie) est déterminée lors du deuxième mode de fonctionnement (64).

7. Procédé selon l'une quelconque des revendications précédentes, dans lequel un changement dans le réseau moyenne ou haute tension (26) est déterminé dans le premier mode de fonctionnement (62), et dans lequel ledit au moins un paramètre de fonctionnement (iSteuer (t)) est mis à jour lorsque le changement est déterminé.

8. Procédé selon l'une quelconque des revendications précédentes,

- dans lequel l'enroulement de réglage (10) est mis hors tension dans le premier mode de fonctionnement (62).

9. Procédé selon l'une quelconque des revendications précédentes,

- dans lequel, lorsque le cas de défaut à la terre (68) est déterminé, l'enroulement de réglage (10) est opéré en fonction dudit au moins un paramètre de fonctionnement (iSteuer (t)) de manière à s'approcher du point de fonctionnement de défaut à la terre (90) précédemment déterminé.

10. Dispositif (40) de compensation d'un défaut à la terre dans un réseau polyphasé moyenne ou haute tension (26), comprenant un enroulement de compensation (4) d'un premier circuit magnétique (8), dans lequel une inductance de l'enroulement de compensation (4) est réglable au moyen d'un enroulement de réglage (10) d'un deuxième circuit magnétique (8), dans lequel le premier circuit magnétique (6) et le deuxième circuit magnétique (8) sont couplés l'un à l'autre au moyen d'une section ferromagnétique (12), dans lequel ledit dispositif comprend en outre:

- des moyens (42) pour déterminer au moins une grandeur de mesure (UNE) caractérisant un défaut à la terre potentiel,
- des moyens (44) pour déterminer au moins un paramètre de fonctionnement (iSteuer(t)) de l'enroulement de réglage (10) en fonction de ladite au moins une grandeur de mesure (UNE), dans lequel ledit au moins un paramètre de fonctionnement (iSteuer(t)) est déterminé de manière pour faire fonctionner l'enroulement de compensation (4) sur un point de fonctionnement de défaut à la terre (90),
- des moyens (44) pour déterminer un cas de défaut à la terre (68) dans le réseau moyenne ou haute tension (26), **caractérisé par le fait que** le dispositif comprend en outre
- des moyens pour déterminer une harmonique d'un courant de défaut à la terre (Ie),

- des moyens pour déterminer un signal de compensation en opposition de phase avec l'harmonique, et
- des moyens pour opérer l'enroulement de réglage (10) en fonction dudit au moins un paramètre de fonctionnement (iSteuer (t)) et du signal de compensation de telle sorte que, sur le point de fonctionnement de défaut à la terre (90), l'enroulement de compensation (4) réduit une amplitude de l'harmonique du courant de défaut à la terre (Ie) .

11. Dispositif (40) selon la revendication 10, comprenant:

- des moyens (44) destinés à, lorsque le cas de défaut à la terre (68) est déterminé, opérer l'enroulement de réglage (10) en fonction dudit au moins un paramètre de fonctionnement (iSteuer (t)) de telle sorte que l'enroulement de compensation (4) se trouve sur le point de fonctionnement de défaut à la terre (90).

12. Dispositif (40) selon la revendication 10 ou 11, qui est conçu pour mettre en œuvre le procédé selon l'une quelconque des revendications 2 à 9.

Fig. 1

Fig. 2

Fig. 3

Fig. 4

Fig. 5

Fig. 6

Fig. 7

Fig. 8

Fig. 9

EP 3 287 796 B1

Fig. 10

EP 3 287 796 B1

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 702814 A
- WO 0215355 A1